# EUROPEAN PATENT APPLICATION

(11) **EP 4 622 054 A1**
(43) Date of publication of application: **24.09.2025**
(21) Application number: 25162562.0
(22) Date of filing: 10.03.2025
(51) Int. Cl.: H02J 7/34

(54) **MULTI-PULSE DRIVE CIRCUIT FOR POWER INTEGRATING LOAD**

(30) Priority: 13.03.2024 US 202418603974
(71) Applicant: NXP B.V., 5656 AG Eindhoven (NL)
(72) Inventor: Villar Piqué, Gerard, 5656AG Eindhoven (NL); Snijder, Bart, 5656AG Eindhoven (NL); Meijer, Rinze Ida Mechtildis Peter, 5656 AG Eindhoven (NL); Huybrechts, Tom, 5656AG Eindhoven (NL)
(74) Representative: Miles, John Richard

(57) **Abstract**

Multi-pulse drive circuits and methods for loads are described. In one example, a drive circuit includes a switch, and a storage capacitor coupled to the switch on one side and to a ground on the other side configured to supply power to the switch. The switch is configured to alternately connect and disconnect the storage capacitor to the load. A control circuit is coupled to the switch, configured to control the operation of the switch to provide a drive cycle to the load, the drive cycle having a series of pulses.

## Description

### BACKGROUND

A class of small mechanical systems use a shape memory alloy (SMA) as a motor instead of a solenoid, stator, linear actuator, or other type of motor. A current applied to the SMA causes the SMA to heat and either expand or contract, depending on the nature of the SMA. Removing the current causes the SMA to return to its original size. The SMA is connected to a drive mechanism, rocker, lever, actuator, or transducer to provide the intended effect.

A shape memory alloy drive uses one or more SMA transducers to convert electrical power into motion. The motion is used to drive a lever, rod, gear, or another mechanical actuator to cause an intended motion. For small devices, the SMA may allow for a much simpler, smaller, and lighter drive than a solenoid, stepper motor, linear actuator, or another electrical drive. Another class of small mechanical systems use resistive heaters. Other classes of systems use loads that integrate the power over time. These systems may be powered by batteries or other low power energy sources.

### SUMMARY

Multi-pulse drive circuits and methods for power integrating loads, *inter alia,* are described. In one example, a drive circuit includes a switch, and a storage capacitor coupled to the switch on one side configured to supply power to the switch. The switch alternately is configured to connect and disconnect the storage capacitor to the load. A control circuit is coupled to the switch, configured to control the operation of the switch to provide a drive cycle to the load, the drive cycle having a series of pulses.

In some embodiments, the control circuit further comprises a stop port to receive a stop signal from the load, the control circuit configured to cause the switch to disconnect the storage capacitor from the load in response to the stop signal.

In some embodiments, the load has an intended range of motion and wherein the stop signal is received upon the load reaching the intended range of motion.

In some embodiments, the control circuit comprises a request port configured to receive a pulse request signal, wherein the control circuit initiates a drive cycle in response to receiving the pulse request signal.

In some embodiments, each pulse of the series of pulses has a voltage greater than a minimum effective voltage of the load.

Some embodiments include a voltage detector coupled to the control circuit configured to detect the voltage of the storage capacitor, and wherein the control circuit is configured to stop a pulse of the series of pulses when the detected voltage is below the minimum effective voltage of the load.

In some embodiments, the control circuit is configured to start a pulse of the series of pulses in response to the detected voltage being above a high drive threshold.

In some embodiments, the control circuit comprises a logic circuit to start a pulse when a storage capacitor voltage exceeds a threshold, a pulse request is received, and no stop signal is received.

In some embodiments, the control circuit comprises a time reference and logic to determine a duration of a pulse, the frequency of the pulses within a drive cycle and the number of the pulses within a drive cycle.

In some embodiments, the power supply comprises a battery having one or more cells.

Some embodiments include a pre-charge circuit coupled to a power supply on one side and to the capacitor on the other side configured to charge the capacitor with power from the power supply.

In some embodiments, the voltage detector is coupled to the pre-charge circuit, wherein the pre-charge circuit comprises a switch between the storage capacitor and the power supply, and wherein the pre-charge circuit is configured to charge the storage capacitor when the detected voltage is below a capacitor fill threshold.

In some embodiments, the pre-charge circuit is configured to disconnect the switch to stop charging the storage capacitor when the detected voltage is above the capacitor fill threshold.

In some embodiments, the pre-charge circuit comprises a resistor coupled at one end to the storage capacitor and coupled to a power supply at an opposite end configured to limit the current from the power supply to the storage capacitor.

In some embodiments, the pre-charge circuit comprises a DC (Direct Current) - DC converter or a current-limited continuous-time voltage regulator configured to control the current to the storage capacitor.

In some embodiments, the load comprises a shape memory alloy wire coupled to a workpiece.

In some embodiments, the load comprises a plurality of loads, the drive circuit further comprising a multiplexing switch coupled to the control circuit to connect the storage capacitor to different ones of the loads in response to the control circuit.

In embodiments, a method includes receiving a drive cycle request at a control circuit, connecting a storage capacitor to a load through a switch between the storage capacitor and the load in response to the drive cycle request, the storage capacitor being coupled to the control circuit, the control circuit operating the switch in a drive cycle having a series of pulses to provide power to the load, and enabling a pre-charge circuit to provide current to storage capacitor during the drive cycle.

Some embodiments include ending the drive cycle in response to receiving a stop signal at the control circuit.

Some embodiments include detecting a voltage at the storage capacitor, wherein enabling the pre-charge circuit comprises enabling the pre-charge circuit to provide current to the storage capacitor in response to detecting a voltage that is below a capacitor fill threshold and disabling the pre-charge circuit to stop providing current to the capacitor in response to detecting a voltage that is above the capacitor fill threshold, and wherein operating the switch comprises disconnecting the storage capacitor from the load in response to detecting a voltage that is below a low drive threshold and reconnecting the storage capacitor to the load in response to detecting a voltage that is above a high drive threshold.

In embodiments, an apparatus includes means for receiving a drive cycle request at a control circuit, means for connecting a storage capacitor to a load through a switch between the storage capacitor and the load in response to the drive cycle request, the switch being coupled to the control circuit, the control circuit operating the switch in a drive cycle having a series of pulses to provide power to the load, and means for enabling a pre-charge circuit to provide current to the storage capacitor during the drive cycle.

### BRIEF DESCRIPTION OF THE DRAWINGS

Fig. 1 is a block diagram of a drive circuit for a load, according to embodiments herein.
Fig. 2 is an example of a timing diagram of the operation of the drive circuit of Fig. 1 for a single SMA wire as the load, according to embodiments herein.
Fig. 3 is a diagram of an example of an SMA multi-wire drive coupled to a drive circuit, according to embodiments herein.
Fig. 4 is a diagram of the example SMA multi-wire drive coupled to the drive circuit in which the drive circuit is coupled to a different one of the multiple wires, according to embodiments herein.
Fig. 5 is a signal timing diagram of example electrical signals involved in driving two time-multiplexed loads, according to embodiments herein.
Fig. 6 is an example of a process flow diagram of operating a capacitor pre-charge circuit, according to embodiments herein.
Fig. 7 is an example of a process flow diagram of an example of operating a drive circuit, according to embodiments herein.
Fig. 8 is a block diagram of an example voltage-detector-based control circuit, according to embodiments herein.
Fig. 9 is a block diagram of an example timing-based control circuit, according to embodiments herein.

### DETAILED DESCRIPTION

Reference throughout this specification to "one embodiment," "an embodiment," or similar language means that a particular feature, structure, or characteristic described in connection with the indicated embodiment is included in at least one embodiment of the present invention. Thus, the phrases "in one embodiment," "in an embodiment," and similar language throughout this specification may, but do not necessarily, all refer to the same embodiment.

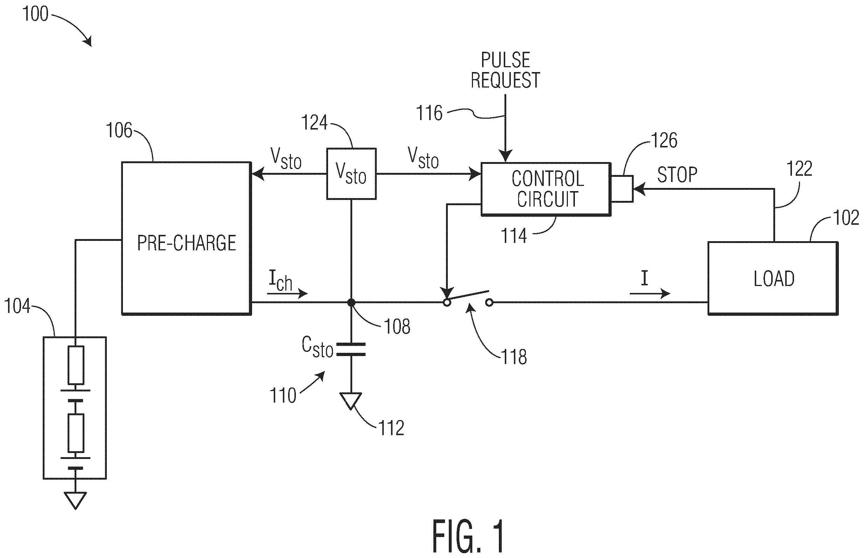

Fig. 1 shows a drive circuit 100 for a load, e.g., a power integrating load. The power integrating load is shown as a load 102. This load may be any combination of wires, SMA transducers or any other power-controlled actuator or transducer coupled to any mechanical device. In some examples, the load is a first SMA wire to pull a lever in one direction and a second SMA wire to pull the lever in the opposite direction at the end of the first wire's cycle. In other examples, the load might be any system that requires a certain amount of energy to operate. The load or the mechanical device may also provide a signal to indicate when enough energy has been provided to the load. The load may be a power integrating load in that it receives the supplied power and integrates the power over voltage and current variations for use in performing the intended work.

A power supply 104 provides the power to cause the load to be activated. The power supply is shown as a battery of two stacked cells, however, any other configuration may be used or the power may come from another device. The power supply is coupled to a pre-charge circuit 106 that is coupled to a capacitor voltage node 108. The capacitor voltage node is coupled to a first side of a storage capacitor 110 and to a ground 112 or other low voltage node on the opposite side. The capacitor voltage node 108 is coupled to a switch 118. The switch 118 is coupled to the load 102. As shown, the capacitor voltage node 108 is coupled directly to the pre-charge circuit 106, the storage capacitor 110, and the switch 118. By supplying power to the load spread over time and assisted by a capacitor instead of directly from a battery, some problematic characteristics of small or low-priced battery cells can be avoided. The current and voltage drop in the supplied power from the battery cells does not affect the load. The high series resistance of multiple series-connected battery cells is also isolated from the load.

The pre-charge circuit 106 may be as simple as a resistor (which may include an enabling switch in series) to limit the pre-charge current or as complex as a DC (Direct Current)-DC converter. A DC-DC boost converter allows the voltage of different cell types and numbers in the power supply to be increased and allows trading off the number of (cheap) cells for the additional cost of the converter. The pre-charge circuit may also be a step-down DC-DC buck converter. If the power supply 104 has a high internal resistance, e.g., a stack of cheap cells, then no resistor may be needed for the pre-charge circuit 106. The internal resistance of the battery serves as the resistor. The pre-charge circuit 106 may be deleted. In some embodiments, the pre-charge circuit 106 also has an internal switch to connect and disconnect the power supply from the capacitor voltage node 108. In some examples, the pre-charge circuit may be implemented as a current source or a current-limited continuous-time voltage regulator, or with a Low Dropout (LDO) linear voltage regulator and switch.

The switch 118 may be a simple switch, e.g., a low resistance field effect transistor that is controlled by a control circuit 114, to couple the storage capacitor to the load in response to a signal received at a pulse request port 116 of the control circuit 114 from an external control component. This switch 118 controls the connection between the capacitor voltage node 108 and the load 102. The control circuit 114 may also include a stop signal port 126 to receive a stop signal 122 from the load 102. The particular configuration of the inputs to the control circuit 114 may be modified to suit different implementations.

An optional voltage detector 124 is coupled to the capacitor voltage node 108 to detect the voltage of the storage capacitor 110. Such a voltage detector may be coupled to the pre-charge circuit 106 and/or to the control circuit 114. In some examples, the voltage information is sent from the voltage detector 124 to the pre-charge circuit 106 and to the control circuit 114. In some examples, the voltage detector 124 compares the detected voltages to thresholds. If the detected voltage falls below a capacitor fill threshold, then the voltage detector 124 sends an enable signal to the pre-charge circuit 106. The pre-charge circuit 106 will charge the storage capacitor 110 until the detected voltage is above the capacitor fill threshold. In some examples, some hysteresis may be added around this threshold, using a low fill threshold and a high fill threshold, to avoid a continuous enable/disable of the pre-charge circuit due to, for example, noise or leakage current.

The voltage detector 124 may also be coupled to the control circuit 114. If the detected voltage is above a high drive threshold, then the voltage detector 124 sends a drive on signal to the control circuit 114 and the control circuit may close the switch 118 to connect the storage capacitor 110 to the load 102. This connection causes the energy stored in the storage capacitor 110 to drive the load 102. In addition, a pulse request signal 116 may be used in some examples by a higher layer to request that a drive cycle be initiated. The control circuit 114 closes the switch only when a pulse request signal 116 has been received. A stop signal 122 or other mechanism may also be used in some examples to end the drive cycle as explained in more detail below. The high drive threshold is a minimum voltage required by the control circuit 114 in order to send a drive cycle of pulses to drive the load 102. If the detected voltage is below a low drive threshold, then the control circuit 114 opens the switch to disconnect the storage capacitor 110 from the load 102. This disconnection stops energy from being supplied to the load 102. For many loads, there is a minimum effective voltage that is required in order for the supplied energy to have the intended effect on the load 102. If the power supplied by the storage capacitor does not meet this minimum voltage, any energy from the storage capacitor will not have the intended effect.

The load 102 responds to a single long pulse with sufficient voltage and current to cause the load to generate the intended motion. This operation requires a capacitor that has sufficient capacity to provide such a long pulse after being charged by the power supply. In order to reduce the size of the capacitor, according to some embodiments, the single long pulse is split into multiple smaller pulses. The storage capacitor is charged by the power supply during and in between each pulse. This reduces the magnitude of current required from the battery cells but allows for a smaller and/or cheaper capacitor. In some embodiments, the drive circuit is operated in a method to power an SMA wire drive, e.g., a wire-based pump, by using multiple small pulses per driving action. The small pulses allow the number of battery cells, their energy, their size, or chemistry to be traded for a storage capacitor. With small pulses, the required capacitance may also be reduced.

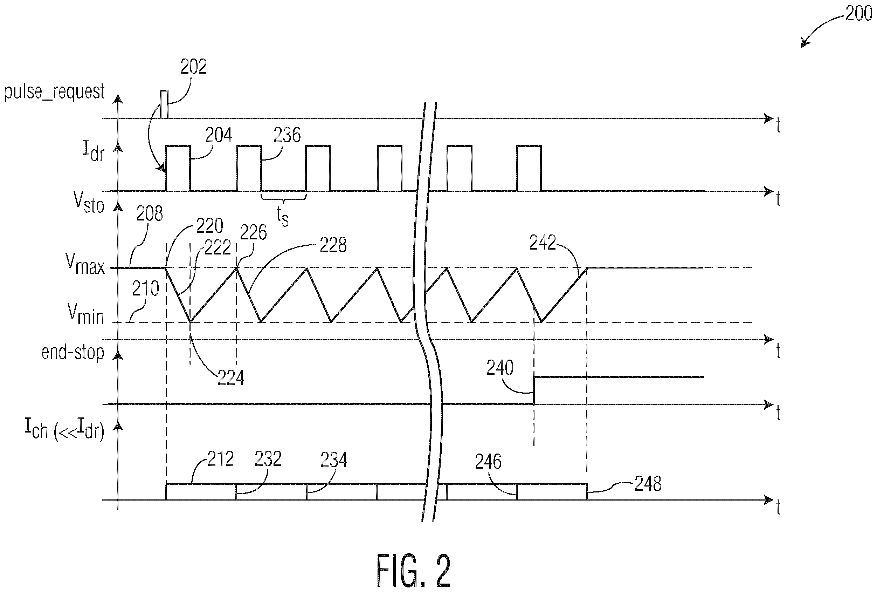

Fig. 2 is an example of a timing diagram of the operation of the drive circuit of Fig. 1 for a single SMA wire as the load. The sequence is initiated by the pulse request 202 at the pulse request port 116 of the control circuit 114 of Fig. 1. In this example case the power supply 104, as a stack of two batteries, is used to pre-charge the storage capacitor 110 to a voltage high enough (*Vₘₐₓ*) 2*08* to deliver a certain amount of stored charge *Qₛ* and remain above a specified minimum (*Vₘᵢₙ*) 210. The high enough voltage may correspond to the high drive threshold and also the capacitor fill threshold. The specified minimum may correspond to the low drive threshold that ends a pulse to the load. The pre-charge current (*I_{ch}*) 212 can be pre-determined or controlled by the pre-charge circuit 106 so that the current supplied from the battery does not exceed a particular value.

In principle, the size of the storage capacitor 110, the difference between *Vₘₐₓ* and *Vₘᵢₙ,* the current taken by the load (*I_{dr}*) and the pre-charge current (*I_{ch}*) determine the frequency of the pulses. The duty-cycle of the pulses is determined by the ratio between *I_{ch}* and *I_{dr}.* The number of required pulses (*n*) is determined by the total amount of energy required by the load (e.g. an SMA wire) to complete its action or operation. These parameters may be configured into the control circuit 114 as predetermined parameter values, e.g. as a pulse width, timing, and number, or may be determined, in full or in part, by the operation of the control circuit 114 with the voltage detector 124.

Initially, a pulse request 202 is received by the control circuit as a single pulse. The shape and configuration of the pulse may be adapted to suit different loads and different uses for the drive circuit and the load. In response to the pulse request 202, the control circuit turns on for a first pulse 204 that connects the storage capacitor directly to the load, e.g., the SMA wire, resistive wire, or other load, e.g., a power integrating load. The storage capacitor voltage which begins at *Vₘₐₓ* 208, above the high drive threshold, starts at time 220 with the first pulse 204 to discharge 222 to the load 102.

After the switch 118 is connected, the storage capacitor voltage as detected by the voltage detector 124 will begin to fall. As soon as the storage capacitor voltage drops below *Vₘₐₓ* 208, or another capacitor fill threshold, the pre-charge circuit 106 is enabled and starts to refill the charge to the storage capacitor as indicated by the positive current *I_{ch}* 212. When the voltage of the storage capacitor drops to *Vₘᵢₙ* at 224, the low drive threshold, the control circuit is turned off while the pre-charge circuit continues to re-charge the storage capacitor at 212. When the voltage of the storage capacitor at *Cₛₜₒ* reaches a maximum specified value (*Vₘₐₓ*) at 226, the control circuit 114 re-enables the switch 118 with a new pulse at 236. The pre-charge circuit may be disabled at 232 and then almost instantaneously re-enabled as the voltage of the storage capacitor droops at 228. The capacitor fill threshold may alternatively be set just above the high drive threshold so that the pre-charge circuit stays on during each pulse until the end of the drive cycle at 242.

The square wave shape of the pulses 204, 236 at the control circuit do not indicate the form of the voltage that is delivered to the load but the duty cycle of the switch that connects the storage capacitor to the load. The voltage delivered to the load is more like the downward portion 222 of the sawtooth wave of the storage capacitor voltage. This represents the voltage at the capacitor voltage node 108.

The operation of connecting and discharging the storage capacitor into the load, while recharging the storage capacitor is repeated until a stop signal 240 is detected. The stop signal may be used to indicate that a wire or other load has reached its intended range of motion or intended temperature, but may also be constructed of a fixed or calculated time. The storage capacitor is recharged at 242 to prepare it for the next cycle using current at 246 from the power supply. The pre-charge circuit 106 disconnects the power supply from the storage capacitor at 248 when the storage capacitor is fully charged, e.g., the storage capacitor voltage at the capacitor voltage node is greater than a capacitor fill threshold, and the system is put to rest until the next pulse request is received. The pre-charge circuit 106 may remain active to keep the storage capacitor charged and ready for the next drive cycle.

As shown, a train of pulses 204, 236 is used to address a single pulse request 202. This drive circuit delivers these pulses without requiring a pulse request for each pulse to the load. In practice, there will likely be multiple pulse requests over a much larger time window as the drive circuit performs its intended function over time. The same drive circuit may be coupled to different loads, e.g., different SMA transducers, different resistive wires, different mechanical devices etc. In one example, a second SMA wire is coupled to the same drive circuit through a switch (not shown) that determines which wire is coupled to the storage capacitor. The two wires may be energized by the same storage capacitor because the wires are energized at different times. For an oscillating lever or rocker in which one wire pulls one direction and the other wire pull in the opposite direction, the power to the two wires may be interleaved.

There is a relationship between the power available from the batteries, the power that can be supplied by the storage capacitor, the duration and frequency of the pulses to the SMA transducer and the physical characteristics of the shape memory alloy transducer in the context of the mechanical drive. The duty-cycle of the pulses 204, 236 is proportional to the pre-charge current 212, which is directly related to or the same as the current supplied by the batteries. While a large number of smaller pulses are able to deliver the same power using a smaller capacitor, there may be a lower limit to these pulses as the SMA transducer may not be sufficiently energized. The selection of the components and the timing of the operation of the system may be selected to suit the particular mechanical drive and its power needs to minimize cost, weight, or volume or to meet another design goal.

In some examples, the operation of Fig. 2 may be accomplished through a common drive circuit clock (not shown) coupled to the pre-charge circuit 106 and the control circuit 114. A separate timing circuit may be provided to control the switching. The power supply 104, the storage capacitor 110, and the load 102 may be characterized in pre-production testing. Suitable timing parameters may then be set for the pre-charge circuit 106 and the control circuit 114 to obtain the voltage outputs of Fig. 2. The stop signal 122 may also be generated based on timing developed in the same pre-production testing.

In some examples, the relative voltages are determined by the voltage detector 124 during the operation of the drive circuit. The pre-charge circuit 106 and control circuit 114 are operated based on detected voltages. This allows the drive circuit to operate consistently as the batteries degrade and without compensating for production variations in the components.

As shown, the pulse request 202 causes the initiation of the pulse 204 at the control circuit. The control circuit may be configured to initiate the pulse 204 only if the detected capacitor voltage is above *Vₘₐₓ* 208. The control circuit continues the pulse until the storage capacitor voltage reaches *Vₘᵢₙ* 224 and turns off the connection to the load. The control circuit may then continue to monitor storage capacitor voltage and when it reaches *Vₘₐₓ* again at 226, the control circuit turns on the connection to the load. In this way the length of each pulse 204, 236 is determined by the voltage at the storage capacitor. The capacitance of the storage capacitor and the characteristics of the load may change, and the voltage detector will cause the system to compensate. While this voltage is affected by many different characteristics of the drive circuit and the load, the control circuit, by detecting and responding to the storage capacitor voltage, automatically compensates for these and any variations in the characteristics of the drive circuit and load over time.

Similarly, the pre-charge circuit 106 may also be configured to act in response to the voltage of the storage capacitor 110. As shown, when the storage capacitor is at *Vₘₐₓ* 208, then the pre-charge circuit does not provide a current 212 to the storage capacitor. This is the initial state before the pulse request 202 and after the stop signal 240. When the storage capacitor drops below *Vₘₐₓ* at 222, then the pre-charge circuit starts charging the storage capacitor at 212. In this way, the operation of the pre-charge circuit 106 and the control circuit may be controlled by the voltage detector 124 at the capacitor voltage node 108.

As mentioned, the voltage supplied to the load from the capacitor voltage node may be a part of a sawtooth waveform with the downward slope 222, 228 of each sawtooth being coupled to the load. Especially in example implementations with sufficient energy/heat conservation in place, a power integrating load, e.g., an SMA wire absorbs this energy almost as well as a longer constant voltage pulse, provided that the applied voltage does not go below some minimum voltage. Accordingly, no smoothing circuit is needed. The load is a power integrating load in that it has a capacitance and inductance sufficient to use the supplied power uneven power and integrate the power internally through the inherent capacitance and inductance or other physical characteristics of the load. In some example, the power integrating load includes internal smoothing circuitry. For other uses, a smoothing circuit (not shown), e.g., inductors, resistors, etc., may be added between the control circuit 114 and the load 102.

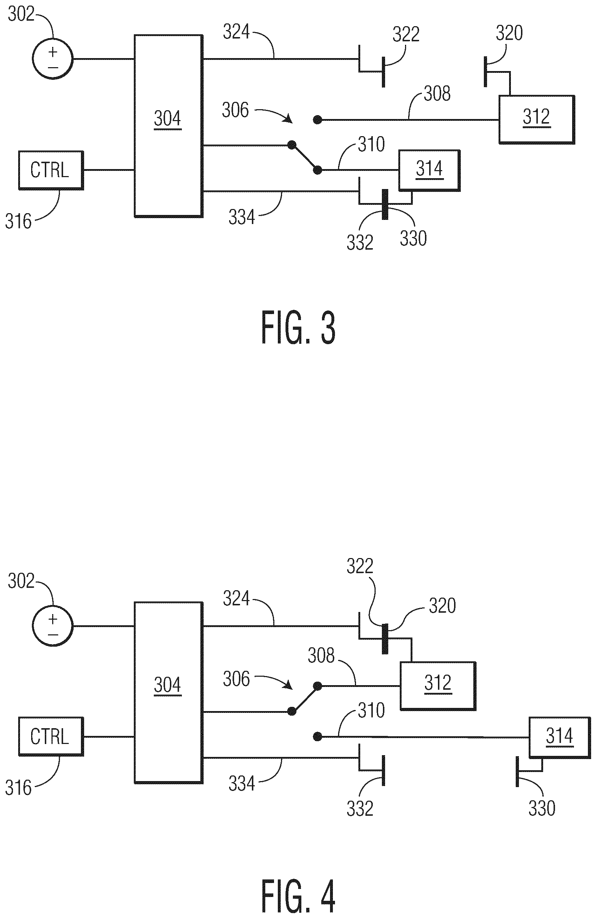

Fig. 3 is a diagram of an example SMA multi-wire drive coupled to a drive circuit. The SMA drive has a first workpiece 312 coupled to a first SMA wire 308 and a second workpiece 314 coupled to a second SMA wire 310. The first workpiece 312 is coupled by being directly or indirectly attached to the first SMA wire 308. The first SMA wire 308 contracts to move the first workpiece. In this example, the first workpiece 312 translates laterally to the left as shown in the drawing as the first SMA wire 308 attached to the left side of the first workpiece 312 contracts. The second workpiece 314 is coupled by being directly or indirectly attached to the second SMA wire 310 which contracts to translate the second workpiece 314 laterally to the left as shown.

The simple lateral motion is shown as an example, the first SMA wire 308 and the second SMA wire 310 may be coupled to other structures to cause a different motion or different motions to occur. There may be more or fewer wires and workpieces. The first workpiece 312 may be attached to the second workpiece 314 directly or through a mechanism to perform work on a workpiece (not shown). The system may include springs and other mechanical components in addition to, or instead of, one of the wires. The SMA wires 308, 310 are coupled through a switch 306 to a drive circuit 304. The drive circuit is powered by a power supply 302 and coupled to a controller 316. In embodiments, the controller generates a pulse request and may have other communications with the controller.

In this example, the loads comprise a first shape memory alloy wire 308 to drive a workpiece 312 and a second shape memory alloy wire 310 to drive a workpiece 314. Using the switch 306 that is coupled to the drive circuit 304, the switch connects the storage capacitor to different ones of the loads in response to the control circuit. The pulses may be interleaved through the switch that multiplexes the drive cycles of pulses. The SMA wires draw the workpieces when energized. As shown, the switch 306 is coupled to the second SMA wire 310 and contracted to move the second workpiece 314 to a position sensor 332 that generates a stop signal 334. In an example, the contact 320 and the stop sensor 322 may be considered as circuit nodes that cause a short when touching. The short between the two nets may be used as a closing of a switch to engage the stop signal 324. The switch 306 is disconnected from the first SMA wire 308 and so the first workpiece 312 is not drawn to a position sensor 322. The first workpiece may be drawn to the right in the drawing by another SMA wire, a spring, or any other suitable source of a force.

In the present description, the SMA wire is referred to as a power integrating load from the perspective of the electrical components of the drive circuit 304, however, a different load may be used including a resistive wire to act as a heater element, or a combination of different power integrating loads may be used. The first workpiece 312 and the second workpiece 314 represent workpieces from the perspective of the SMA wires. These workpieces may be any suitable workpieces with any suitable mechanical structure. For a resistive heater, the workpiece may be a substance to be heated or any other suitable workpiece.

Fig. 4 is a diagram of the example SMA multi-wire drive coupled to the drive circuit in which the drive circuit is coupled to a different one of the multiple wires. Accordingly, the workpieces are moved by the SMA wires. The first workpiece 312 has a contact 320 attached, directly, or indirectly, to the first workpiece 312. When the contact reaches a position sensor 322, a stop signal 324 is generated. In Fig. 3, the first workpiece contact 320 is displaced from the position sensor 322 and no stop signal 324 is generated. Similarly, in Fig. 3, the second workpiece 314 has a contact 330 that is in contact with a position sensor 332 to generate a stop signal 334. In Fig. 4, the second workpiece has moved away from the position sensor by the force of the spring, an SMA wire or another component and no stop signal 334 is generated. The contact and position sensor show an electrical connection used for when the workpiece has reached the end of its intended range of motion, however, any other type of sensor may be used. Another sensor may be used to determine motion in the opposite direction.

The SMA drive, a timer, a motion sensor, or any other suitable component or sensor may also be used to generate a stop signal 324, 334, e.g., when the first workpiece 312 has reached its intended range of motion. The stop signal 324 is coupled to the drive circuit 304 to end the drive cycle of the first SMA wire 308 when the first workpiece 312 has completed a drive cycle of the SMA drive. The drive circuit 304 ends the drive cycle by no longer energizing the first drive wire 310. In some embodiments, the drive circuit then energizes another SMA drive wire to drive the first workpiece 312 back to the rest position of Fig. 3 or to accomplish another movement.

As shown, the switch 306 is coupled to the first SMA wire 308 which is contracted to move the first workpiece 312 to a position sensor 322 that generates a stop signal 324. The switch 306 is disconnected from the second SMA wire 310 and so the second workpiece 314 is not drawn to a position sensor 332.

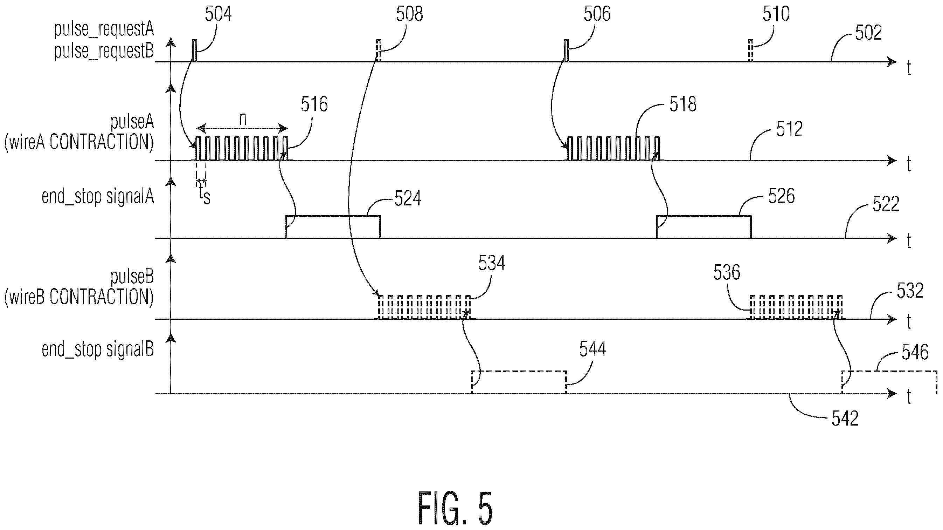

Fig. 5 is a signal timing diagram of example electrical signals involved in driving two time-multiplexed loads, e.g., an SMA drive of Fig 3 or Fig. 1. Other types of loads may be driven in the same way. The top line 502 is the pulse request signal from the controller 316 to the drive circuit. The second line 512 is the lower SMA wire drive signal 516, 518 generated by the drive circuit 304 and used to energize the lower SMA wire 310. The drive signal pulses 516 are generated by the drive circuit in response to receiving the lower pulse request 504, 506. As the SMA drive wire pulls the workload, the workload reaches the end of its drive cycle and hits the stop. The third line 522 is the stop signal 524, 526. The stop signal 524, 526 at the drive circuit causes the drive circuit to end the SMA wire drive cycle of pulses signal 516, 518. The stop signal may persist for more or less time as the lower SMA wire relaxes to its start condition.

Upper pulse requests 508, 510 are generated by the controller and sent to the drive circuit to drive the upper SMA wire 308. The drive circuit in response generates right SMA wire drive signals 534, 536, shown on the fourth line to energize the right SMA wire in response to the pulse requests. The upper workpiece is driven by the upper SMA wire until it reaches a stop and a stop signal 544, 546 is generated. The stop signals 544, 546 cause the drive circuit to stop energizing the upper SMA wire 308. When the upper SMA wire relaxes, another lower pulse request begins a new drive cycle.

The drive signal pulses are shown as examples. There may be only upper drive cycle pulses or lower drive cycle pulses. The pulses may be spaced or numbered as is suitable for the nature of the SMA drive. The illustrated SMA drive may be modified or exchanged for any other suitable SMA drive and any other suitable workpiece or combination of workpieces. The SMA transducer may be a wire of any suitable length, and shape or a different configuration of materials.

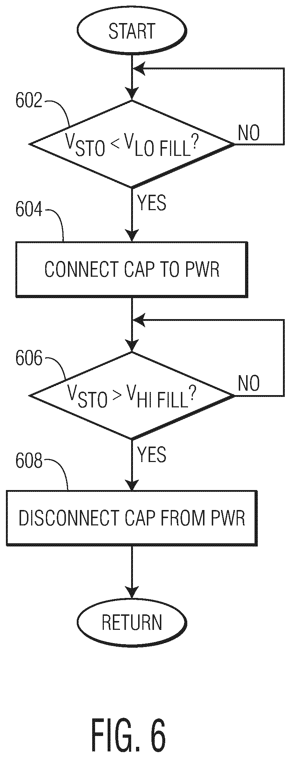

Fig. 6 is an example of a process flow diagram of operating a capacitor pre-charge circuit as described above. At 602, the voltage at the storage capacitor is detected. This may be performed during the entire operation of the drive circuit. The detected storage capacitor voltage V_{STO} is compared to a low capacitor fill threshold V_{LO FILL} to determine whether to charge the storage capacitor. If the storage capacitor voltage is not below the low capacitor fill threshold, then the process returns to the start. The storage capacitor may have lost charge due to current leakage or through connecting to the drive circuit. In particular, as the storage capacitor is discharging to the SMA drive, the storage capacitor voltage provides information that may be used to operate the pre-charge circuit. At 604, if the storage capacitor voltage is below the low capacitor fill threshold, then the pre-charge circuit is coupled to the storage capacitor. The pre-charge circuit provides current to the storage capacitor to charge the storage capacitor in response to detecting a voltage that is below the low capacitor fill threshold.

At 606 the detected storage capacitor voltage V_{STO} is compared to a high capacitor fill threshold V_{HI FILL}. If the detected storage capacitor voltage is below the high capacitor fill threshold, then the process returns and makes the comparison again as the storage capacitor continues to be charged by the power supply. If the storage capacitor voltage exceeds the high capacitor fill threshold, then at 608 the pre-charge circuit is disabled or disconnected from the storage capacitor at 608 and the process returns to the start until the detected voltage is again below the low capacitor fill threshold. In summary, the pre-charge circuit may autonomously receive the detected storage capacitor voltage and be disabled at 608 to stop providing current to the storage capacitor in response to detecting a voltage that is above the high capacitor fill threshold. The pre-charge circuit may also autonomously be enabled at 604 to provide current to the storage capacitor in response to detecting a voltage that is below the low capacitor fill threshold.

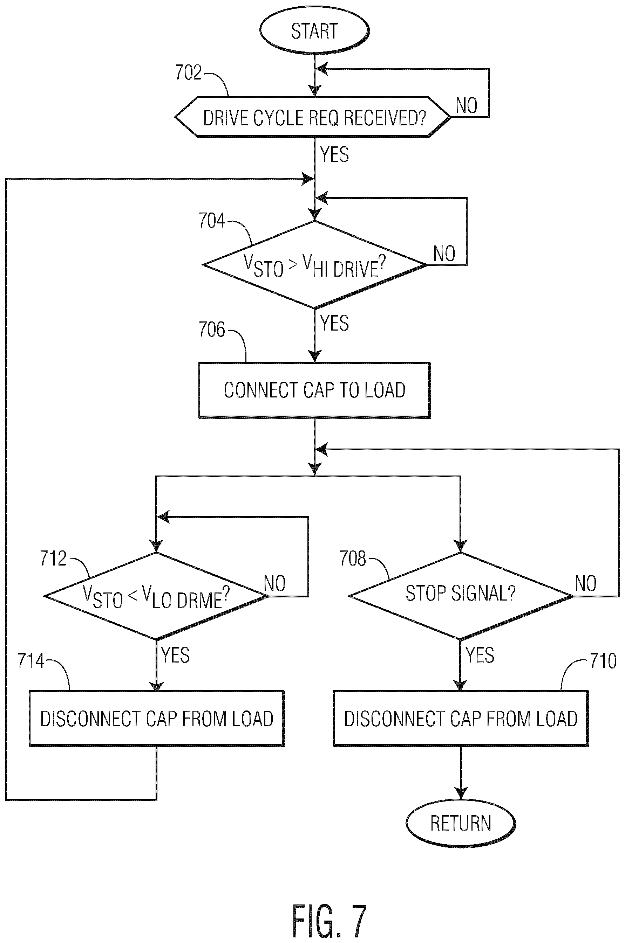

Fig. 7 is an example of a process flow diagram of operating a drive circuit as described above. The process begins at 702 with receiving a drive cycle request at the control circuit of the drive circuit, e.g. a wire driver. The process returns until a drive cycle request is received. At 704, if a drive cycle request has been received, then the detected storage capacitor voltage V_{STO} is compared to a high drive voltage threshold, V_{HI DRIVE}. This test is to determine if the storage capacitor has enough stored charge to drive the load. If the detected storage capacitor voltage exceeds the high drive voltage threshold, then the control circuit responds to the pulse request by connecting the storage capacitor of the drive circuit to a load at 706, e.g., an SMA wire for an SMA drive. The storage capacitor discharges to the SMA drive. In embodiments, the storage capacitor is directly coupled to the SMA material without any need for filtering, smoothing or other circuitry.

At 712, the storage capacitor voltage detected during the discharge of the storage capacitor into the SMA drive, falls below a low voltage drive threshold, V_{LO DRIVE}. The charge on the storage capacitor is reduced for as long as the storage capacitor is coupled to the load. After some time, in response to the comparison at 712, the storage capacitor is disconnected at 714 from the SMA drive in response to the detected storage capacitor voltage being below the low voltage drive threshold. The storage capacitor may be receiving current to charge the storage capacitor before and after it is disconnected from the load by the pre-charge circuit and the process of Fig. 6. The process returns to the test at 704 to determine whether the detected storage capacitor voltage V_{STO} is above the high voltage drive threshold V_{HI DRIVE}. If so then a new pulse begins at 706 by connecting the storage capacitor to the load. If not, then the process waits until the detected storage capacitor voltage is increased further.

In examples, the current from the pre-charge circuit is less than the current to the load. As a result, the storage capacitor is discharged by the load even while being charged by the pre-charge circuit. After the load is disconnected at 714, the pre-charge circuit is able to increase the charge on the storage capacitor until at 704 the storage capacitor voltage is greater than the high voltage drive threshold. At 706, the storage capacitor is coupled the load, and a new drive pulse begins, discharging the storage capacitor again. The process may repeat from 704 to 714 to provide power to energize the SMA drive by connecting the storage capacitor, disconnecting, and recharging the storage capacitor and connecting the storage capacitor again until the SMA drive has performed the requested work.

For some SMA drive configurations, the drive circuit may also be coupled to a stop signal. The process may include receiving a stop signal at 708 at the control circuit and ending the drive cycle at 710 by disconnecting the storage capacitor from the load in response to the stop signal. The process then returns to the start to wait for another drive cycle request at 702.

The process of Fig. 6 and the process of Fig. 7 are connected only by the storage capacitor voltage V_{STO}. The two processes my operate independently of each other or there may be an explicit link through a share controller, timer, event manager etc.

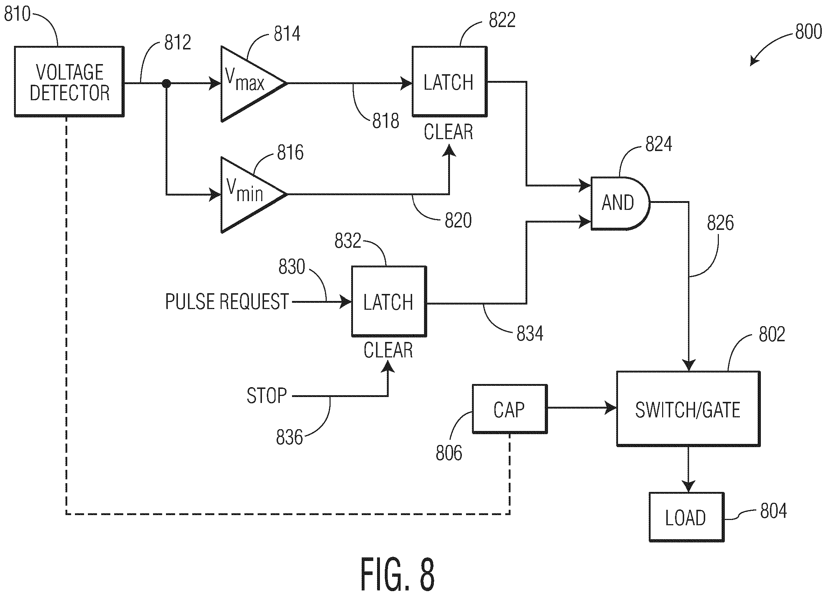

The control circuit 114 of Fig. 1 operates the switch 118 that connects the storage capacitor 110 to the load 102. As shown in Fig. 3, there may be multiple switches for multiple loads. The control circuits, as inputs, receives the storage capacitor voltage V_{STO} from the voltage detector 124, the pulse request signal 116 and the stop signal 122. The control circuit operates the switch 118 based on these inputs. The control circuit may take any of a variety of suitable forms and one such form is shown in Fig. 8.

Fig. 8 is a block diagram of an example voltage-detector-based control circuit 800 suitable for use with the various embodiments described herein. The control circuit 800 generates a drive ON/OFF signal 826 to set the state of a switch or gate 802. The switch or gate 802 alternatively connects and disconnects a storage capacitor 806 to and from a load 804. The voltage-detector-based control circuit 800 is coupled to a voltage detector 810 that detects the voltage of the storage capacitor 806 in any suitable manner. The voltage detector sends a voltage signal 812 to a high voltage drive threshold comparator 814 and to a low voltage drive threshold comparator 816. While a signal switch or gate 802 is shown for a single load 804, there may be multiple switches and multiple loads to suit different configurations.

Alternatively, the comparators may be incorporated into the voltage detector. If the voltage signal 812 exceeds the high voltage drive threshold, then the high voltage drive threshold comparator 814 generates a high drive signal 818 is sent to a latch 822 and sets the latch 822 high. If the voltage signal 812 is below the low voltage drive threshold, then the low voltage drive threshold comparator 832 sends a clear signal 820 to the latch 822 to reset the latch 822 to low. The latch 822 controls the sending of each pulse from the start of the pulse when the latch is set high to the end of the pulse when the latch is reset low. The duration of the pulse is controlled by the voltage of the storage capacitor 806 as measured by the voltage detector 810 and, accordingly, is determined by the characteristics of the capacitor, the characteristics of the load, the path between the two, the voltage drive thresholds (high and low) and the magnitude and operation of the pre-charge current.

The control circuit 800 also receives a pulse request signal 830 at a second latch 832. The pulse request signal 830 sets the latch 832 high which generates a request signal 834 to an AND gate 824. The AND gate receives the request signal 834 and the latch 822 signal output and if both are high then it sends a drive signal 826 to the switch or gate 802 to connect the storage capacitor to the load. If either input is not high, meaning that the storage capacitor has insufficient voltage or no drive cycle is requested (or the drive cycle is already ended) or both, then the drive signal 826 is low and the switch or gate 802 disconnects the storage capacitor 806 from the load 804.

The control circuit 800 also receives a stop signal 836 from the load, a timer, or another component. The stop signal 836 indicates the end of the drive cycle, e.g. because the load or attached workpiece has reached its intended range of motion or temperature. The stop signal 836 is applied to the second latch 832 to clear the second latch 832 and reset the output request signal 834 to low. This ends the drive signal 826 at the AND gate 824. The example logic-based control circuit may be modified to have more or fewer inputs and outputs and any signal indicated as high may be converted to low with suitable adjustments to the components herein. The described logic may be implemented using different logic circuits or different types of logic circuits and may alternatively be implemented as firmware or software in a suitable integrated circuit, or may even be implemented using alternative but equivalent analog building blocks.

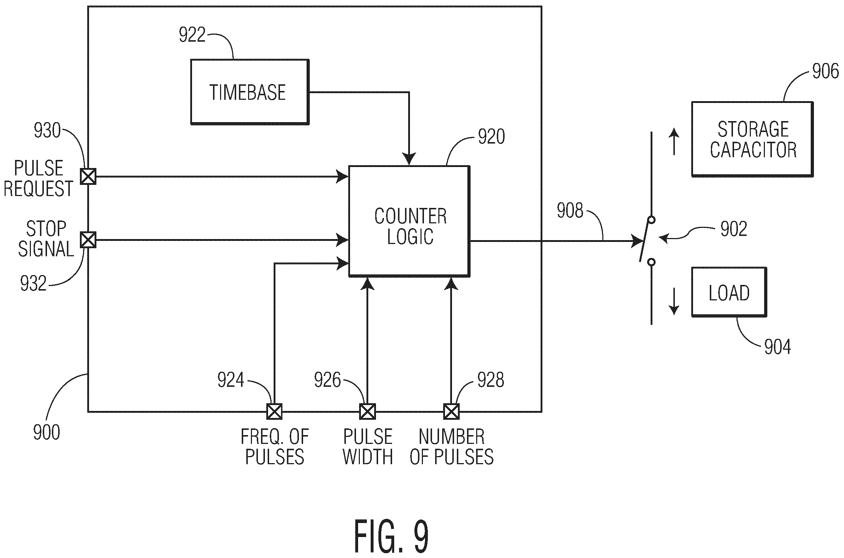

Fig. 9 is a block diagram of an example timing-based control circuit 900 suitable for use with the various embodiments described herein. The control circuit 900 uses a time base 922 as a timing reference that is applied to counter logic 920 to determine the state of a drive signal 908. The drive signal 908 determines the state of the switch 902 to connect a storage capacitor 906 to a load 904. While a single switch 902 is shown, there may be multiple switches and loads to suit different configurations.

The control circuit 930 receives a pulse request 930 at a first port. The pulse request 930 intimates a drive cycle of pulses. The pulse request is received at the counter logic which then generates a sequence of pulses. The pulses are based on the time base 922 and stored parameters. The parameters may include a frequency of the pulses 924, e.g., the duration between the beginning of each pulse, a pulse width 926, e.g. the duration between the start and the stop of each pulse, and the number of pulses 928, i.e. how many pulses are provided in response to a single pulse request. These parameters may be set by first characterizing the system of the storage capacitor 906, the load 904, and a power supplied to recharge the capacitor.

The counter logic 920 operates the switch 902 using the drive signal 908 to generate pulses with the stored parameters of the frequency of pulses, pulse width, and number of pulses to achieve a single drive cycle. The counter logic may take any suitable form with counters, gates, and other components to operate the drive signal 908. In some examples, a stop signal may be coupled to the control circuit 900 at a stop signal port 932 instead of or in addition to the number of pulses parameter and applied to the counter logic or to a separate gate to end the drive cycle. The output of the voltage-detector-based control circuit and the timing-based control circuit are similar and will cause a similar drive current to a load. The voltage-detector-based control circuit allows the system operation to adapt to changes and variations in the system components. The timing-based control circuit eliminates the cost of the detectors and comparators and provides a consistent and reliable drive signal. The timing-based control circuit may be more suitable for implementations in which the components can be accurately characterized and remain stable through their expected lifespan.

Boundaries between the above-described operations are provided as examples. Multiple operations may be combined into a single operation, a single operation may be distributed in additional operations and operations may be executed at least partially overlapping in time. Moreover, alternative embodiments may include multiple instances of a particular operation, and the order of operations may be altered in various other embodiments.

Multi-pulse drive circuits and methods for loads are described. In one example, a drive circuit includes a switch, and a storage capacitor coupled to the switch on one side and to a ground on the other side configured to supply power to the switch. The switch is configured to alternately connect and disconnect the storage capacitor to the load. A control circuit is coupled to the switch, configured to control the operation of the switch to provide a drive cycle to the load, the drive cycle having a series of pulses.

Although the operations of the method(s) herein are shown and described in a particular order, the order of the operations of each method may be altered so that certain operations may be performed in an inverse order or so that certain operations may be performed, at least in part, concurrently with other operations. In another embodiment, instructions or sub-operations of distinct operations may be implemented in an intermittent and/or alternating manner.

It should also be noted that at least some of the operations for the methods described herein may be implemented using software instructions stored on a computer useable storage medium for execution by a computer. As an example, an embodiment of a computer program product includes a computer useable storage medium to store a computer readable program.

Alternatively, embodiments of the invention may be implemented entirely in hardware or in an implementation containing both hardware and software elements. In embodiments which use software, the software may include but is not limited to firmware, resident software, microcode, etc.

The connections as discussed herein may be any type of connection suitable to transfer signals or power from or to the respective nodes, units, or devices, including via intermediate devices. The connections may be illustrated or described in reference to being a single connection, a plurality of connections, unidirectional connections, or bidirectional connections. However, different embodiments may vary the implementation of the connections. For example, separate unidirectional connections may be used rather than bidirectional connections and vice versa. Also, a plurality of connections may be replaced with a single connection that transfers multiple signals serially or in a time multiplexed manner. Likewise, single connections carrying multiple signals may be separated out into various different connections carrying subsets of these signals. The term "coupled" or similar language may include a direct physical connection or a connection through other intermediate components even when those intermediate components change the form of coupling from source to destination.

The described examples may be implemented on a single integrated circuit, for example in software in a digital signal processor (DSP) as part of a radio frequency integrated circuit (RFIC). The described examples may also be implemented in hardware in a field programmable gate array (FPGA) or application specific integrated circuit (ASIC), or in other electronic devices. The described examples may be implemented in analog circuitry, digital circuitry, or a combination of analog and digital circuitry. Alternatively, the circuit and/or component examples may be implemented as any number of separate integrated circuits or separate devices interconnected with each other in a suitable manner. These examples may alternatively be implemented as software or code representations of physical circuitry or of logical representations convertible into physical circuitry, such as in a hardware description language or any other appropriate form.

It will be readily understood that the components of the embodiments as generally described herein and illustrated in the appended figures may be arranged and designed in a wide variety of different configurations. Thus, the more detailed description of various embodiments, as represented in the figures, is not intended to limit the scope of the present disclosure but is merely representative of various embodiments. While the various aspects of the embodiments are presented in drawings, the drawings are not necessarily drawn to scale unless specifically indicated.

The present invention may be embodied in other specific forms without departing from its essential characteristics. The described embodiments are to be considered in all respects only as illustrative and not restrictive. The scope of the invention is, therefore, indicated by the appended claims rather than by this detailed description. All changes which come within the meaning and range of equivalency of the claims are to be embraced within their scope.

Reference throughout this specification to features, advantages, or similar language does not imply that all of the features and advantages that may be realized with the present invention should be or are in any single embodiment of the invention. Rather, language referring to the features and advantages is understood to mean that a specific feature, advantage, or characteristic described in connection with an embodiment is included in at least one embodiment of the present invention. Thus, discussions of the features and advantages, and similar language, throughout this specification may, but do not necessarily, refer to the same embodiment.

Furthermore, the described features, advantages, and characteristics of the invention may be combined in any suitable manner in one or more embodiments. One skilled in the relevant art will recognize, in light of the description herein, that the invention may be practiced without one or more of the specific features or advantages of a particular embodiment. In other instances, additional features and advantages may be recognized in certain embodiments that may not be present in all embodiments of the invention.

Although specific embodiments of the invention have been described and illustrated, the invention is not to be limited to the specific forms or arrangements of parts so described and illustrated. The scope of the invention is to be defined by the claims appended hereto and their equivalents.

## Claims

1. A drive circuit for a load, the circuit comprising:
a switch;
a storage capacitor coupled to the switch on one side and configured to supply power to the switch, the switch configured to alternately connect and disconnect the storage capacitor to the load; and
a control circuit coupled to the switch, configured to control the operation of the switch to provide a drive cycle to the load, the drive cycle having a series of pulses.

2. The drive circuit of claim 1, wherein the control circuit further comprises a stop port configured to receive a stop signal from the load, the control circuit to cause the switch to disconnect the storage capacitor from the load in response to the stop signal.

3. The drive circuit of claim 2, wherein the load has an intended range of motion and wherein the stop signal is received upon the load reaching the intended range of motion.

4. The drive circuit of any preceding claim, wherein the control circuit comprises a request port configured to receive a pulse request signal, wherein the control circuit initiates a drive cycle in response to receiving the pulse request signal.

5. The drive circuit of any preceding claim, wherein each pulse of the series of pulses has a voltage greater than a minimum effective voltage of the load.

6. The drive circuit of claim 5, further comprising:
a voltage detector coupled to the control circuit configured to detect the voltage of the storage capacitor, and
wherein the control circuit is configured to stop a pulse of the series of pulses when the detected voltage is below the minimum effective voltage of the load.

7. The drive circuit of claim 6, wherein the control circuit is configured to start a pulse of the series of pulses in response to the detected voltage being above a high drive threshold.

8. The drive circuit of any preceding claim, wherein the control circuit comprises a logic circuit to start a pulse when a storage capacitor voltage exceeds a threshold, a pulse request is received, and no stop signal is received.

9. The drive circuit of any preceding claim, wherein the control circuit comprises a time reference and logic to determine a duration of a pulse, the frequency of the pulses within a drive cycle and the number of pulses within a drive cycle.

10. The drive circuit of any preceding claim, wherein the power supply comprises a battery having one or more cells.

11. The drive circuit of any preceding claim, further comprising a pre-charge circuit coupled to a power supply on one side and to the capacitor on the other side configured to charge the capacitor with power from the power supply.

12. The drive circuit of claim 11, wherein the voltage detector is coupled to the pre-charge circuit, wherein the pre-charge circuit comprises a charge switch between the storage capacitor and the power supply, and wherein the pre-charge circuit is configured to connect the switch to charge the storage capacitor when the detected voltage is below a capacitor fill threshold.

13. The drive circuit of claim 11 or 12, wherein the pre-charge circuit is configured to disconnect the charge switch to stop charging the storage capacitor when the detected voltage is above the capacitor fill threshold.

14. The drive circuit of any of claims 11 to 13, wherein the pre-charge circuit comprises a resistor coupled at one end to the storage capacitor and coupled to a power supply at an opposite end configured to limit the current from the power supply to the storage capacitor.

15. The drive circuit of any of claims 11 to 14, wherein the pre-charge circuit comprises a DC (Direct Current) - DC converter or a current-limited continuous-time voltage regulator configured to control the current to the storage capacitor.
